Europäisches Patentamt

European Patent Office

Office européen des brevets

(19)

(11) Numéro de publication : **0 166 839**
**B1**

(12) **FASCICULE DE BREVET EUROPÉEN**

(45) Date de publication du fascicule du brevet :
17.05.89

(51) Int. Cl.⁴ : **G 01 R 25/00, H 04 L 1/24**

(21) Numéro de dépôt : **84430026.9**

(22) Date de dépôt : **29.06.84**

(54) **Procédé et dispositif de mesure de la gigue de phase d'un canal de transmission.**

(43) Date de publication de la demande :
08.01.86 Bulletin 86/02

(45) Mention de la délivrance du brevet :
17.05.89 Bulletin 89/20

(84) Etats contractants désignés :
DE FR GB IT

(56) Documents cités :
US—A— 3 737 766
ELEKTRONIK UND MASCHINENBAU, vol. 95, no. 2, 1978,Reutlingen; F. COENNING "MeBgeräte für die Datenübertragungstechnik", pages 82-88

(73) Titulaire : **International Business Machines Corporation**
**Old Orchard Road**
**Armonk, N.Y. 10504 (US)**
**DE GB IT**
**Compagnie IBM FRANCE**
**5 Place Vendôme**
**F-75000 Paris 1er (FR)**
**FR**

(72) Inventeur : **Godard, Dominique**
**24, Chemin du Moulin OPIO**
**F-06650 Le Rouret (FR)**

(74) Mandataire : **de Pena, Alain**
**Compagnie IBM France Département de Propriété Intellectuelle**
**F-06610 La Gaude (FR)**

EP 0 166 839 B1

Jouve, 18, rue St-Denis, 75001 Paris, France

**Description**

### Domaine technique

La présente invention concerne les systèmes de transmission de données, et plus particulièrement un procédé et un dispositif pour mesurer la gigue de phase qui affecte la transmission des données à travers un canal de transmission.

### Etat de la Technique

Un système de transmission de données comprend typiquement un émetteur et un récepteur reliés entre eux par un canal de transmission. L'émetteur reçoit les données à transmettre en provenance de l'équipement terminal de données qui lui est associé, les convertit en signaux impulsionnels appropriés à une transmission correcte à travers le canal de transmission, puis les transmet à travers ce canal. Le récepteur reçoit les signaux en provenance du canal de transmission, les convertit en données puis transfère ces dernières à l'équipement terminal de données associé. En pratique, et pour des raisons essentiellement économiques, on utilise le plus souvent des lignes téléphoniques à bande vocale comme canal de transmission. Les lignes téléphoniques, si elles sont bien adaptées à une transmission correcte de la parole, le sont moins lorsqu'il s'agit de transmettre des signaux impulsionnels à une vitesse élevée et avec un taux d'erreur très faible. On comprendra aisément que la conception de l'émetteur et du récepteur, et notamment le choix des caractéristiques des signaux impulsionnels à utiliser et des méthodes à mettre en œuvre pour extraire les données des signaux reçus, est liée à une bonne connaissance des paramètres du canal de transmission qui vont affecter la transmission des signaux impulsionnels.

Parmi les paramètres qui affectent la transmission des signaux à travers un canal de transmission téléphonique à bande vocale, on peut citer la distorsion de temps de groupe, la dérive en fréquence, la gigue de phase, etc... On trouvera une description de ces paramètres dans, par exemple, le document « Transmission Parameters Affecting Voiceband Data Transmission-Description of Parameters », July 1974, Bell System Technical Reference PUB 41 008. Ces paramètres affectent la transmission des signaux avec des degrés différents, et en général, les émetteurs et récepteurs de données sont conçus de façon à compenser les effets de ces paramètres, du moins lorsque ceux-ci varient dans des limites bien définies.

Dans les systèmes de transmission de données à vitesse élevée, la gigue de phase est un paramètre important dont il est nécessaire de compenser les effets. Le brevet français FR-A-2 296 322 illustre une des techniques de compensation utilisées aujourd'hui, et qui permettent de compenser continuellement la gigue de phase au cours d'une transmission normale de données. Un inconvénient de ces techniques est qu'elles ne permettent de compenser les effets de la gigue que lorsque celle-ci varie dans des limites connues, typiquement lorsque la gigue de phase reste en dessous de 15° crête à crête. Dans le cas où la valeur de la gigue de phase dépasse cette limite, beaucoup d'erreurs se produisent, et il est nécessaire d'interrompre la transmission des données afin de procéder au diagnostic du système.

Les récents développements des circuits intégrés et des microprocesseurs ont permis l'incorporation de systèmes de diagnostics à l'intérieur des modems — un modem regroupant un émetteur et un récepteur — qui permettent un contrôle permanent du fonctionnement des systèmes de transmission de données et permettent un diagnostic de ces systèmes en cas de mauvais fonctionnement. L'article « Network Problem Determination Aids in Microprocessor-Based Modems », par S. Huon et R. Smith, paru dans la revue IBM Journal of Research and Development, Vol. 25, n° 1, January 81, décrit un tel système de diagnostic. Dans ce système, la qualité du signal reçu est mesurée en permanence et sa valeur est reportée au système hôte qui contrôle le réseau incorporant le système de transmission de données. Ce système de diagnostic ne fournit aucune indication précise sur l'amplitude de la gigue de phase, et il s'est avéré utile de compléter l'information de qualité du signal reçu par une mesure précise de la gigue de phase afin de permettre un diagnostic correct du système de transmission.

L'Avis 091 du CCITT « Essential Clauses for an Instrument to Measure Phase Jitter on Telephone Circuits » propose une méthode de mesure de la gigue de phase qui comprend l'application d'un signal de test au canal de transmission à tester et la mesure de la gigue de phase à partir du signal de test reçu. Cette dernière mesure comprend les étapes suivantes :

limitation de la bande du signal reçu autour de la fréquence du signal de test,

amplification et limitation du signal pour en éliminer la modulation d'amplitude incidente, et

détection des passages à zéro d'un signal d'erreur fourni par une boucle à verrouillage de phase.

L'inconvénient majeur de la méthode proposée est qu'elle ne se prête pas à une réalisation numérique précise ; il est difficile, par exemple, d'obtenir une détection précise des passages à zéro avec les techniques numériques.

Le document Elektronik und Maschinenbau, Vol. 95, No 2, 1978, F. Coenning, « Messgeräte für die Datenübertragungstechnik », pages 82-88, décrit un système de mesure de la gigue de phase d'un canal de transmission mettant en œuvre une méthode voisine de celle décrite ci-dessus. Dans ce système, un signal de test est généré côté transmission puis transmis à travers le canal de transmission. Côté réception, le signal de test reçu est filtré par un filtre passe-bande puis combiné avec un signal de référence pour fournir un signal d'erreur dont la phase est représentatrice de la gigue de phase. Le signal de référence est dérivé du signal d'erreur au moyen d'une boucle à verrouillage de phase à grande constante de temps. Le signal d'erreur est ensuite écrété puis appliqué à un dispositif de mesure de phase qui fournit une mesure de la gigue de phase.

Tout comme la méthode proposée par le CCITT, celle présentée dans le document ci-dessus ne se prête pas à une réalisation numérique précise ; elle exige notamment aussi une mesure des passages à zéro d'un signal pour en déterminer la phase.

## Exposé de l'Invention

L'objet de l'invention est de fournir un procédé et un dispositif de mesure de la gigue de phase très précis et qui puissent être facilement mis en œuvre dans un environnement numérique.

Le procédé de l'invention pour mesurer la gigue de phase d'un canal de transmission du type dans lequel un signal de test sinusoïdal de fréquence donnée est appliqué à une extrémité du canal de transmission, et la gigue de phase affectant la phase du signal de test reçu à l'autre extrémité du canal de transmission est mesurée, est caractérisé en ce qu'il comprend les étapes suivantes :

la détermination de la phase du signal de test reçu à l'autre extrémité du canal de transmission,
la génération de la phase du signal de test transmis,
la soustraction de la phase de signal de test générée de celle du signal de test reçu, cette opération fournissant un premier signal phase,
le filtrage de ce premier signal de phase pour en éliminer les composantes d'écart de phase et de dérive en fréquence, cette opération fournissant un second signal de phase,
le filtrage passe-bas de ce second signal de phase, cette opération fournissant un troisième signal de phase, et
le filtrage prédictif du troisième signal de phase pour en déterminer une valeur estimée de la gigue de phase.

Selon un autre aspect de l'invention, la détermination de la phase du signal de test reçu comprend les étapes suivantes :

la détermination des composantes en phase et en quadrature du signal de test reçu, et
la détermination de la phase du signal de test reçu à partir de ces composantes.

L'invention propose aussi un dispositif pour mettre en œuvre le procédé de l'invention.

D'autres objets, caractéristiques et avantages de la présente invention ressortiront mieux de l'exposé qui suit, fait en référence aux dessins annexés à ce texte, qui représentent un mode de réalisation préféré de l'invention.

## Brève Description des Figures

La figure 1 représente schématiquement un système de mesure conforme à l'invention.
La figure 2 est un diagramme qui illustre le fonctionnement du dispositif de calcul de phase 26 de la figure 1.
La figure 3 représente un exemple de réalisation du filtre de phase 36 de la figure 1.
La figure 4 représente un exemple de réalisation du filtre prédictif 40 de la figure 1.

## Description Détaillée de l'Invention

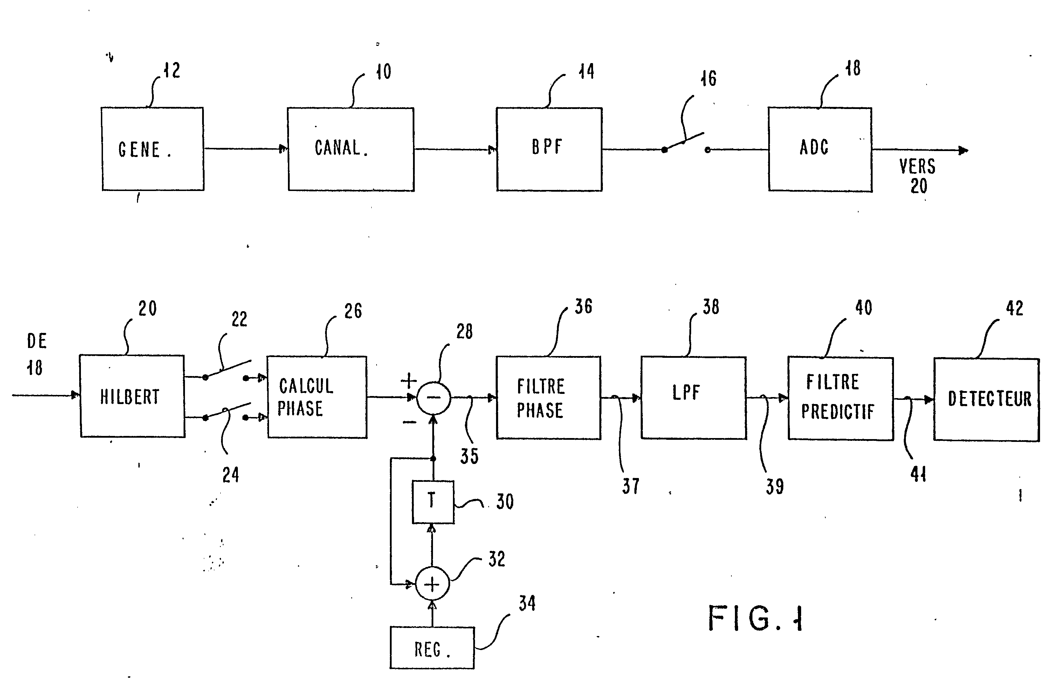

Sur la figure 1, on a représenté par un bloc 10 le canal de transmission dont on veut mesurer la gigue de phase.

La méthode de l'invention est basée sur l'application d'un signal de test à une extrémité du canal et l'analyse du signal reçu à l'autre extrémité. Le signal de test utilisé est un signal sinusoïdal de fréquence donnée, et choisie de préférence dans la bande du canal où l'atténuation est minimum, c'est-à-dire dans la bande 1 000-2 000 Hz. Ce signal de test peut être engendré par tout moyen approprié qu'on a illustré sur la figure 1 par un générateur de signal 12.

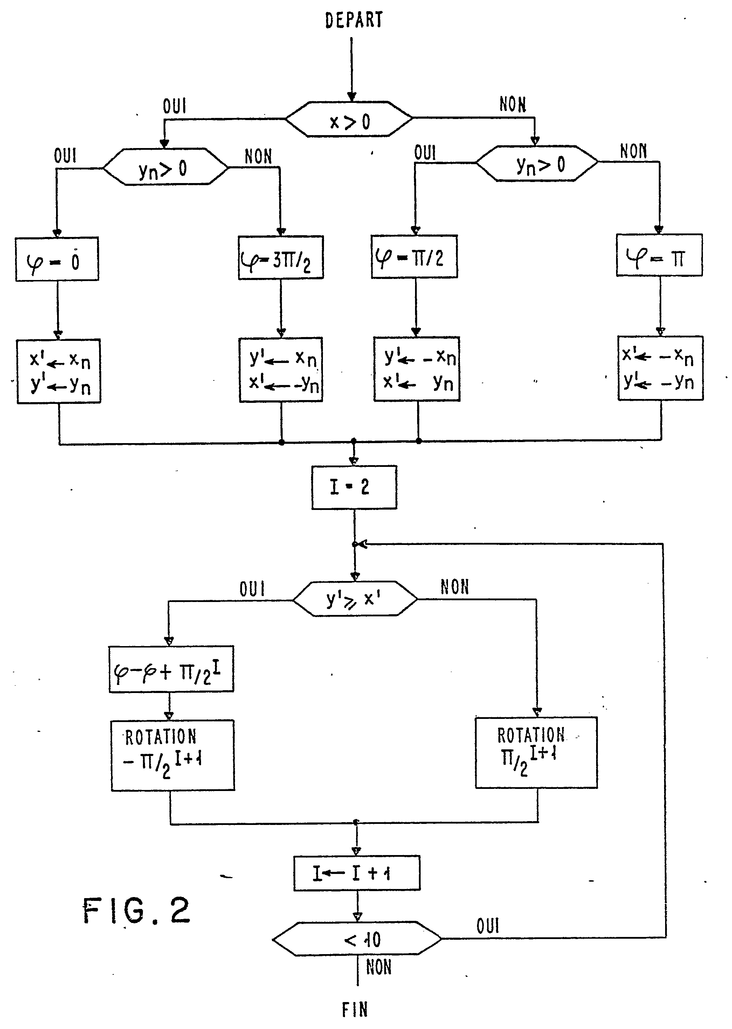

Le signal reçu du canal de transmission 10 est appliqué à l'entrée d'un filtre analogique passe-bande (BPF) 14 qui limite la bande passante du signal reçu à la bande vocale. Un tel filtre est un élément connu dans l'art et qu'on retrouve par exemple à l'entrée de tous les modems à bande vocale. La sortie du filtre 14 est échantillonnée par un dispositif d'échantillonnage 16, et convertie en numérique par un convertisseur analogique-numérique ADC 18. La sortie du convertisseur ADC 18 est appliquée à un transformateur de Hilbert 20 qui fournit à ses sorties les composantes en phase et en quadrature du signal reçu échantillonné. Ces deux composantes sont échantillonnées respectivement dans deux dispositifs de prélèvement périodique d'échantillons, dits dispositifs de décimation, 22 et 24, puis appliquées à un dispositif de calcul de phase 26 qui sera décrit en référence à la figure 2.

La sortie du dispositif 26 est appliquée à l'entrée (+) d'un soustracteur numérique 28 dont l'entrée (—) est reliée à la sortie d'un élément à retard 30. L'entrée de l'élément à retard 30 est reliée à la sortie d'un additionneur numérique 32 dont une entrée est reliée à la sortie de l'élément à retard 30 et l'autre entrée reçoit le contenu d'un registre 34.

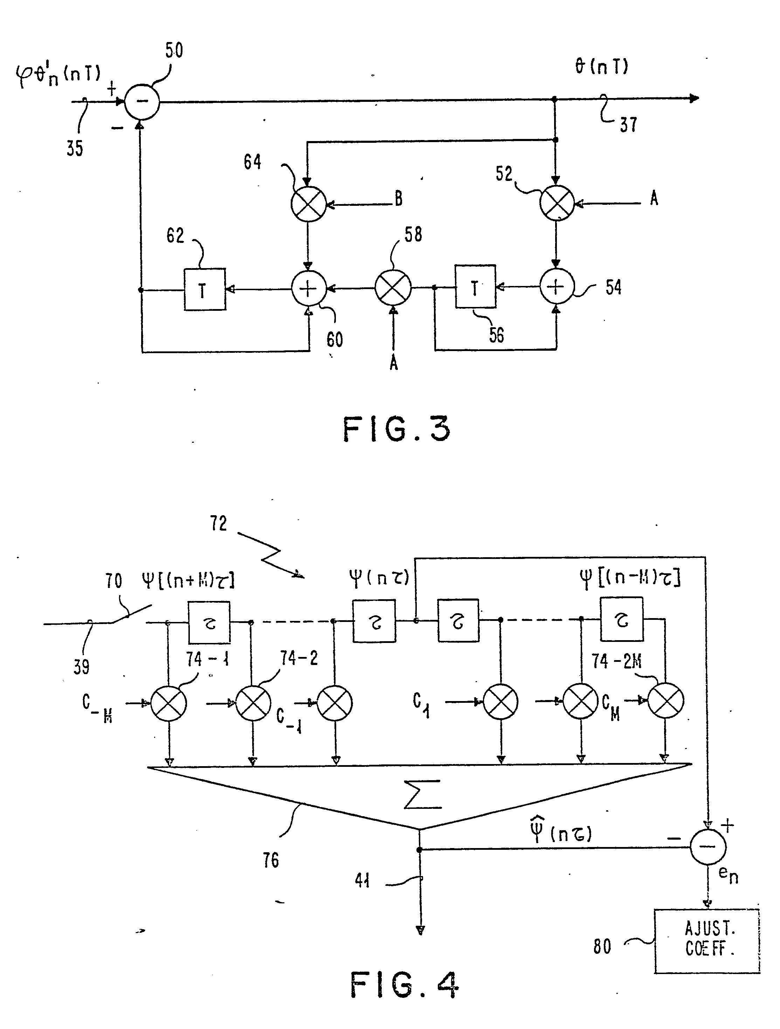

La sortie du soustracteur 28 est appliquée par une ligne 35 à un filtre de phase du second ordre 36 qui sera décrit en détail en référence à la figure 3. La sortie du filtre de phase 36 est appliquée par une ligne 37 à un filtre numérique passe-bas (LPF) 38 ayant une fréquence de coupure de 300 Hz. La sortie du filtre LPF 38 est appliquée par une ligne 39 à un filtre numérique prédictif 40 qui sera décrit en référence à la figure 4. La sortie du filtre prédictif 40 est appliquée par une ligne 41 à un détecteur de valeur crête qui fournit une mesure de la valeur crête à crête de la gigue de phase.

Tous les dispositifs illustrés sur la figure 1 autres que ceux décrits en référence aux figures 2 à 4 sont des dispositifs bien connus dans l'art, qu'on retrouve aujourd'hui dans les modems, et ne seront pas décrits ici avec plus de détails.

On décrira maintenant le fonctionnement du système de l'invention illustré sur la figure 1. Le signal de test généré par le générateur de signal 12 et noté s(t), peut s'exprimer sous la forme :

$$s(t) = A_0 \cos 2 \pi f_0 t \tag{1}$$

où $A_0$ et $f_0$ représentent respectivement l'amplitude et la fréquence du signal de test transmis.

A cause des perturbations introduites par le canal, le signal de test reçu noté r(t) est différent du signal de test transmis s(t). En l'absence de distorsion non linéaire, le signal de test reçu r(t) peut se mettre sous la forme :

$$r(t) = A_1(1 + m(t)) \cos (2 \pi f_0 t + \emptyset_1 + \emptyset(t)) + n(t) \tag{2}$$

ou

$A_1$ et $\emptyset_1$ représentent respectivement l'amplitude et la phase du canal à la fréquence $f_0$,

m(t) est la modulation d'amplitude incidente introduite par le canal,

$\emptyset(t)$ est la modulation de phase incidente introduite par le canal, et n(t) représente le bruit.

La modulation de phase incidente peut se mettre sous la forme :

$$\emptyset(t) = \emptyset_0 + 2 \pi \Delta ft + \sum_{k=1}^{N} j_k \cos (2 \pi f_k t + \emptyset_k) \tag{3}$$

où

$\emptyset_0$ est une constante qui représente l'écart de phase introduit par le canal,

$\Delta f$ représente la dérive en fréquence introduite par le canal, et $j_k$, $f_k$ et $\emptyset_k$ représentent N composantes indépendantes de la gigue de phase.

Les relations (2) et (3) ci-dessus sont bien connues dans l'art et on les retrouvera, par exemple, dans le document précité Bell System Technical Référence, PUB 41008, sous les références (4.2), et (4.3). On trouvera aussi dans ce document la définition et la description des différents termes des relations (2) et (3).

Le problème adressé par l'invention est la mesure des extrêmes de la somme

$$\sum_{k=1}^{N} j_k \cos (2 \pi f_k t + \emptyset_k)$$

dans la relation (3).

Le signal de test reçu du canal de transmission 10 est passé à travers le filtre BPF 14 qui limite le signal reçu à ses composantes dans la bande vocale. Le signal reçu r(t) est échantillonné à une cadence satisfaisant au théorème de l'échantillonnage, et que l'on a choisie dans l'exemple illustré sur la figure 1 égale à 6/T où 1/T = 2 400 Hz. Le signal de test reçu et échantillonné est appliqué au transformateur de Hilbert 20 qui en dérive de façon connue les composantes en phase et en quadrature qui elles-mêmes sont appliquées au dispositif de calcul de phase 26 qui en dérive la phase du signal de test reçu. Etant donné que le signal représentant la phase du signal reçu a une bande passante inférieure à celle du signal reçu, il n'est pas nécessaire de disposer de 6/T échantillons du signal de phase par seconde, et c'est pourquoi on a intercalé les dispositifs de décimation 22 et 24 entre le transformateur de Hilbert 20 et le dispositif de calcul de phase 26. Les dispositifs de décimation 22 et 24 ne prennent qu'un sur six des échantillons fournis par le transformateur de Hilbert 20 et fournissent ainsi respectivement les composantes en phase et en quadrature) à la cadence 1/T. On notera respectivement ces composantes par $x_n$ et $y_n$, où n est l'index de temps, n = 1, 2, 3... Le dispositif de calcul de phase 26 fournit des échantillons de la phase du signal reçu comme il sera décrit ultérieurement en référence à la figure 2.

A l'instant t = nT, la valeur de phase fournie par le dispositif 26 est de la forme :

$$\emptyset(nT) = \emptyset_0 + 2 \pi f_0 nT + 2 \Delta f nT + \sum_{k=1}^{N} j_k \cos (2 \pi f_k nT + \emptyset_k) + \Delta \emptyset(nT) \tag{4}$$

où $\Delta \emptyset(nT)$ représente l'influence du bruit n(t).

4

EP 0 166 839 B1

Le terme $2\pi f_0 nT$ dans la relation (4), qui représente la phase du signal de test transmis est généré par l'ensemble constitué par l'élément à retard 30 qui introduit un retard de T secondes, l'additionneur 32, et le registre 34, et soustrait de la phase $\emptyset(nT)$ au moyen du soustracteur 28. La variation de phase $2\pi f_0 T$ est une constante dont la valeur codée en numérique est stockée dans le registre 34, et est additionnée toutes les T secondes au contenu de l'élément à retard 30 au moyen de l'additionneur 32. On obtient ainsi à la sortie du soustracteur 28 la valeur de phase :

$$\emptyset'(nT) = \emptyset_0 + 2\pi \Delta f\, nT + \sum_{k=1}^{N} j_k \cos\left(2\pi f_k\, nT + \emptyset_k\right) + \Delta\emptyset(nT) \qquad (5)$$

la valeur de phase $\emptyset'(nT)$ ainsi obtenue est appliquée au filtre de phase 36 qui en enlève les termes $\emptyset_0$ et $2\pi\Delta fnT$ représentatifs respectivement de l'écart de phase et de la dérive en fréquence. Après la convergence du filtre 36, on obtient à sa sortie une valeur de phase $\theta(nT)$ qu'on peut exprimer sous la forme :

$$\emptyset(nT) = \sum_{k=1}^{N} j_k \cos\left(2\pi f_k\, nT + \emptyset_k\right) + \Delta\theta(nT) \qquad (6)$$

où $\Delta\theta(nT)$ représente un bruit résiduel.

Etant donné que les composantes de la gigue de phase sont concentrées dans la bande 20-300 Hz, on a prévu le filtre passe-bas 38 pour limiter $\theta(nT)$ a ses composantes inférieures à 300 Hz. Dans l'exemple de réalisation illustré sur la figure 1, on a utilisé comme filtre passe-bas un filtre numérique transversal symétrique à quinze prises. La sortie du filtre passe-bas 38 contient les composantes d'intérêt de la gigue de phase, mais aussi un bruit résiduel. Dans certaines conditions, la mesure de la sortie du filtre passe-bas 38 peut être suffisante pour avoir une bonne indication de la gigue de phase, mais lorsque le canal de transmission est utilisé par des modems à très haute vitesse (12 000 bits/s et au-dessus), la gigue de phase est une perturbation importante qui doit être mesurée avec plus de précision que n'en fournirait une mesure de la sortie du filtre passe-bas 38. C'est pour cela qu'on a prévu le filtre prédictif 40 qui élimine le bruit résiduel du signal de sortie du filtre 38. On obtient alors à la sortie du filtre prédictif 40 une valeur de phase représentative de la gigue de phase avec une très bonne précision. L'amplitude crête à crête de la gigue de phase est mesurée par le détecteur 42 qui compare entre eux les échantillons successifs fournis par le filtre prédictif 40 pendant la durée du test et qui fournit à l'issue du test l'écart maximum d'amplitude entre ces échantillons.

On décrira maintenant un exemple de réalisation du dispositif de calcul de phase 26 en se référant à la figure 2 qui représente un diagramme illustrant la méthode de calcul utilisée. Selon cette méthode, la phase $\emptyset(nT)$ du signal défini par ses composantes en phase et en quadrature $x_n$ et $y_n$ est déterminée par des rotations successives du vecteur de coordonnées $(x_n, y_n)$ autour de $\pi/4$.

Lorsqu'un couple de composantes, par exemple le couple $(x_n, y_n)$ est appliqué au dispositif 26, le signe de $x_n$ est testé.

Si $x_n$ est positif, on teste le signe de $y_n$. Dans le cas où $y_n$ est positif, on force une variable $\emptyset$ à zéro, et on donne à deux variables intermédiaires $x'$ et $y'$ les valeurs de $x_n$ et $y_n$ respectivement. Dans le cas où $y_n$ est négatif, on force $\emptyset$ à $3\pi/2$ tandis que les variables $x'$ et $y'$ prennent respectivement les valeurs $x_n$ et $-y_n$.

Si $x_n$ est négatif, on teste aussi le signe de $y_n$. Dans le cas où $y_n$ est positif, on force $\emptyset$ à $3\pi/2$ tandis que les variables $x'$ et $y'$ prennent respectivement les valeurs $y_n$ et $-x_n$. Dans le cas où $y_n$ est négatif, on force $\emptyset$ à $\pi$, tandis que les variables $x'$ et $y'$ prennent respectivement les valeurs $-x$ et $-y$. Une fois les valeurs des variables $x'$ et $y'$ initialisés comme défini ci-dessus, on force une variable de comptage 1 à 2 et on compare $x'$ et $y'$. Si $y'$ est supérieur ou égal à $x'$, la variable $\emptyset$ reçoit la valeur définie à l'étape précédente à laquelle on rajoute $\pi/2^l$. On procède alors à une rotation du vecteur de composantes $x'$ et $y'$ d'un angle égal à $-\pi/2^{l+1}$, rotation qui résulte en de nouvelles valeurs de $x'$ et $y'$ comme indiqué ci-dessous.

$x'$ nouveau $\longleftarrow x'$ anc. $\cos \pi/2^{l+1} + y'$ anc. $\sin \pi/2^{l+1}$

$y'$ nouveau $\longleftarrow y'$ anc. $\cos \pi/2^{l+1} - x'$ anc. $\sin \pi/2^{l+1}$

Si $y'$ est inférieur à $x'$, le vecteur de composantes $x'$ et $y'$ est soumis à une rotation de $\pi/2^{l+1}$ qui résulte en de nouvelles valeurs de $x'$ et $y'$ comme indiqué ci-dessous.

$x'$ nouveau $\longleftarrow x'$ anc. $\cos \pi/2^{l+1} - y'$ anc. $\sin \pi/2^{l+1}$

$y'$ nouveau $\longleftarrow y'$ anc. $\cos \pi/2^{l+1} - x'$ anc. $\sin \pi/2^{l+1}$

Une fois l'une ou l'autre de ces opérations de rotation effectuée et de nouvelles valeurs de $x'$ et $y'$ obtenues, la variable de comptage I est augmentée d'une unité. Un test est effectué sur la valeur de I, et dans le cas où cette valeur est inférieure à un seuil, ici fixé à 10, l'opération de comparaison de $x'$ à $y'$, et les opérations subséquentes sont effectuées en tenant compte des nouvelles valeurs de I, $x'$, et $y'$. Lorsque I a atteint la valeur du seuil, l'opération de calcul de phase est terminée, et la dernière valeur de $\emptyset$ représente la valeur de phase recherchée. L'homme de l'art comprendra que le dispositif de calcul de

5

phase 26 peut être réalisé de toute manière appropriée en utilisant la méthode illustrée par le diagramme de la figure 2 qui vient d'être décrit.

On décrira maintenant un exemple de réalisation du filtre de phase 36 en se référant à la figure 3. La phase $\emptyset'$ (nT) est appliquée par la ligne 35 à l'entrée (+) d'un soustracteur binaire 50 dont la sortie est reliée à la ligne de sortie 37 du filtre de phase 36 et à une entrée d'un multiplicateur 52 qui reçoit sur son autre entrée la valeur codée en numérique d'un coefficient A. La sortie du multiplicateur 52 est appliquée à une entrée d'un additionneur 54 dont la sortie est appliquée à un élément à retard 56 qui introduit un retard de T secondes. La sortie de l'élément à retard 56 est reliée à l'autre entrée de l'additionneur 54 et à une entrée d'un multiplicateur 58 qui reçoit sur son autre entrée la valeur codée en numérique du coefficient A. La sortie du multiplicateur 58 est appliquée à une entrée d'un additionneur à trois entrées 60 dont la sortie est appliquée à un élément à retard 62 qui introduit un retard de T secondes. La sortie de l'élément à retard 62 est appliquée à l'entrée (—) du soustracteur 50 et à une autre entrée de l'additionneur 60. La sortie du soustracteur 50 est en outre appliquée à une entrée d'un multiplicateur 64 qui reçoit sur son autre entrée la valeur codée en numérique d'un coefficient B et qui a sa sortie reliée à la troisième entrée de l'additionneur 60.

Le filtre de phase 36 utilisé est un filtre récursif du second ordre dont la fonction de transfert est :

$$\frac{(1 - Z^{-1})^2}{1 - (2 - B)Z^{-1} + (1 + A^2 - B)Z^{-2}}$$

où $Z^{-1}$ correspond à un retard de T secondes.

Les coefficients de ce filtre sont déterminés de façon à ce que ce filtre ait les trois caractéristiques suivantes :

il doit laisser passer les composantes de la gigue de phase,

il doit rejeter les composantes d'écart de phase et de dérive en fréquence, et

il ne doit pas avoir une vitesse de convergence trop lente.

A partir de ces trois caractéristiques la valeur des coefficients peut être déterminée selon les méthodes connues dans l'art comme, par exemple, celles décrites dans les articles suivants : « Equiripple and Minimas Approximation for Recursive Digital Filters » IEEE Transactions on Acoustics, Speech, Signal Processing, Vol. ASSP-22 pp. 98-111, April 1974 et « A Design Algorithm for Constrained Equiripple Digital Filters » IEEE Trans. Acoustics, Speech Signal Processing, Vol. ASSP-30, pp. 206-211, April 1982. Dans l'exemple de réalisation illustré sur la figure 3 on a utilisé les valeurs suivantes :

A = 0,09961

B = 0,049805

T = 1/2400

On décrira maintenant en se référant à la figure 4 un exemple de réalisation du filtre prédictif 40 de la figure 1. Soit $\Psi$(nT) la sortie du filtre passe-bas 38. D'après la relation (6), puisque les fréquences fk sont inférieures à 300 Hz, la sortie du filtre 38 peut se mettre sous la forme

$$\Psi(nT) = \sum_{k=1}^{N} j_k \cos (2 \pi f_k nT + \emptyset_k) + \Delta\Psi(nT) \qquad (8)$$

où $\Delta\Psi$ est simplement la version filtrée du bruit résiduel $\Delta\theta$(nT) dans la relation (6).

Le spectre du signal défini par la relation (8) est limité à 300 Hz, et ce signal peut donc être observé à une cadence inférieure à 1/T qu'on a choisie égale à $1/\tau = 1/4T$. Il faut aussi noter que la fonction de transfert du filtre de phase 36 et du filtre passe-bas 38 en cascade est plate sur la bande 0-300 Hz, à l'exception d'un nul prononcé à la composante continue. La corrélation entre les échantillons de bruit successifs est donc très faible. Par contre, les composantes de la gigue de phase sont fortement corrélées entre elles. Les effets du bruit peuvent être lisses en prédisant à partir des échantillons antérieurs de la sortie du filtre passe-bas 38 une valeur estimée $\hat{\Psi}$(n$\tau$) de $\Psi$(n$\tau$).

La valeur estimée $\hat{\Psi}$(n$\tau$) de $\Psi$(n$\tau$) est choisie sous la forme :

$$\Psi(n\tau) = \sum_{p=-M, p \neq 0}^{N} \Psi[(n - p)\tau] C_p \qquad (9)$$

où Cp représente les coefficients à valeurs réelles d'un filtre transversal dont les prises sont espacées de $\tau$ secondes, avec le coefficient central fixé à zéro. La valeur des coefficients est ajustée de façon adaptive de façon à minimiser l'erreur quadratique moyenne Ee$_n^2$, où E représente l'espérance mathématique, ou valeur moyenne, et l'erreur e$_n$ est définie par la relation suivante :

$$e_n = \Psi(n\tau) - \Psi(n\tau) \qquad (10)$$

6

la valeur des coefficients Cp est ajustée par itérations successives en utilisant la méthode stochastique définie par la relation :

$$Cp(n+1) = Cp(n) + Ie_n \, \Psi[(n-p)\tau], \quad p \neq 0$$

où 1 est le pas d'itération dont la valeur sera discutée ultérieurement. Le filtre prédictif illustré sur la figure 4 est un filtre prédictif de type Wiener connu et qui utilise les relations. La sortie du filtre passe-bas 38 est appliquée par la ligne 39 à un dispositif de décimation 70 qui ne laisse passer qu'un sur quatre des échantillons fournis par le filtre 38. La sortie du dispositif de décimation 70 est appliquée à l'entrée d'une ligne à retard numérique 72 à 2M+1 prises, les prises étant séparées entre elles par un retard de r secondes. Toutes les prises à l'exception de la prise centrale sont appliquées à une entrée de 2M multiplicateurs 74-1 à 74-2M qui reçoivent respectivement sur leur autre entrée les 2M coefficients $C_{-M}...C_{-1}...C_1...C_M$. Les sorties des multiplicateurs 74-1 à 74-2M sont appliquées aux entrées d'un dispositif de sommation 76 dont la sortie est appliquée par la ligne 41 au détecteur 42 de la figure 1. La sortie du dispositif de sommation 76 est aussi appliquée à l'entrée (—) d'un soustracteur 76 dont l'entrée (+) est reliée à la prise centrale de la ligne à retard 72 et dont la sortie est appliquée à un dispositif d'ajustement des coefficients 80 qui fournit la valeur des coefficients appliqués aux multiplicateurs 74-1 à 74-2M.

Initialement, la valeur des coefficients est mise à zéro. A l'instant où l'échantillon $\Psi(n\tau)$ est à la prise centrale, les échantillons

$$\Psi[(n-M)\tau], ... \Psi[(n-1)\tau], \Psi[(n+1)\tau], ... \Psi[(n+M)\tau]$$

sont répartis aux diverses prises de la ligne à retard 70 comme indiqué sur la figure, et les coefficients ont les valeurs Cp(n).

On obtient alors à la sortie du dispositif de sommation 76 la valeur estimée $\hat{\Psi}(n\tau)$ conformément à la relation (9). Cette valeur estimée est retranchée de $\Psi(n\tau)$ dans le soustracteur 78 qui fournit à sa sortie l'erreur en qui est elle même appliquée au dispositif d'ajustement 80 qui calcule la nouvelle valeur des coefficients conformément à la relation (9).

A l'instant d'échantillonnage suivant, l'échantillon $\Psi[(n+1)\tau]$ est à la prise centrale, et une valeur estimée $\hat{\Psi}[(n+1)\tau]$ de $\Psi[(N+1)\tau]$ est calculée en utilisant les coefficients Cp(n+1) calculés à l'itération précédente à partir de l'erreur $e_n$. Le procédé d'itération se répète de façon semblable.

Le nombre de prises de la ligne à retard 72 doit être choisi aussi large que possible pour obtenir des performances optima du système. De très bons résultats furent obtenus avec une ligne à retard à 27 prises. La valeur du pas d'itération est choisie empiriquement et de façon conventionnelle en faisant un compromis entre la précision désirée et le temps de convergence souhaité pour le procédé itératif.

On notera que la plupart des éléments du système de l'invention sont des éléments qui existent déjà dans les modems, et que l'utilisation de l'invention ne nécessite qu'un minimum d'équipement supplémentaire. On notera aussi que les cadences d'échantillonnages nécessaires pour utiliser l'invention sont compatibles avec celles utilisées dans les modems, par exemple, la cadence 1/T-2400 est une cadence largement utilisée dans les modems.

## Revendications

1. Procédé pour mesurer la gigue de phase d'un canal de transmission, dans lequel un signal de test sinusoïdal de fréquence donnée ($f_0$) est appliqué à une extrémité du canal de transmission, et la gigue de phase affectant la phase du signal de test reçu à l'autre extrémité du canal de transmission est mesurée, caractérisé en ce qu'il comprend les étapes suivantes :

la détermination de la phase ($\emptyset(nT)$) du signal de test reçu (r(t)) à l'autre extrémité du canal de transmission,

la génération de la phase ($2\pi f_0 nT$) du signal de test transmis,

la soustraction de la phase de signal de test générée de celle du signal de test reçu, cette opération fournissant un premier signal de phase ($\emptyset'(nT)$),

le filtrage de ce premier signal de phase pour en éliminer les composantes d'écart de phase et de dérive en fréquence, cette opération fournissant un second signal de phase (sortie de 36),

le filtrage passe-bas de ce second signal de phase, cette opération fournissant un troisième signal de phase (sortie de 38), et

le filtrage prédictif du troisième signal de phase pour en déterminer une valeur estimée de la gigue de phase.

2. Procédé selon la revendication 1, caractérisé en ce que la détermination de la phase du signal de test reçu comprend les étapes suivantes :

la détermination des composantes en phase et en quadrature (xn et yn) du signal de test reçu, et

la détermination de la phase du signal de test reçu à partir de ces composantes.

3. Dispositif pour mesurer la gigue de phase d'un canal de transmission du type comprenant des moyens pour générer un signal de test sinusoïdal de fréquence donnée et l'appliquer à une extrémité du canal de transmission, et des moyens pour mesurer la gigue de phase affectant la phase du signal de test reçu à l'autre extrémité du canal de transmission, caractérisé en ce qu'il comprend :

des moyens (20, 22, 24, 26) pour déterminer la phase du signal de test reçu à l'autre extrémité du canal de transmission,

des moyens (30, 32, 34) pour générer la phase du signal de test transmis,

des moyens (28) pour soustraire la phase de signal de test générée de celle du signal de test reçu, et fournir un premier signal de phase,

un filtre récursif du second ordre (36) pour éliminer de ce premier signal de phase les composantes d'écart de phase et de dérive en fréquence, et fournir un second signal de phase,

un filtre passe-bas (38) pour filtrer ce second signal de phase, et fournir un troisième signal de phase, et

un filtre prédictif et adaptatif (40) pour déterminer une valeur estimée de la gigue de phase à partir dudit troisième signal de phase.

4. Dispositif selon la revendication 3, caractérisé en ce que les moyens pour déterminer la phase du signal de test reçu comprennent :

un transformateur de Hilbert (20) pour déterminer les composantes en phase et en quadrature du signal de test reçu, et

un dispositif de calcul (26) pour calculer la phase du signal de test reçu à partir de ces composantes.

5. Dispositif selon la revendication 4, caractérisé en ce que le signal reçu est échantillonné (16) à une première cadence avant d'être appliqué au transformateur de Hibert (20), les composantes en phase et en quadrature du signal de test conçu sont échantillonnées (22, 24) à une seconde cadence qui est un sous-multiple de ladite première cadence, et le troisième signal de phase est échantillonné (70) à une troisième cadence qui est un sous-multiple de ladite seconde cadence.

## Claims

1. A method of measuring phase jitter on a transmission channel, wherein a sinusoidal test signal of a given frequency ($f_0$) is applied to one end of the transmission channel and the phase jitter affecting the phase of the test signal received at the other end thereof is measured, characterized in that it includes the steps of :

determining the phase ($\emptyset(nT)$) of the test signal ($r(t)$) received at the other end of the transmission channel,

generating the phase ($2\pi f_0 nT$) of the transmitted test signal,

subtracting the test signal phase thus generated from that of the received test signal, thereby providing a first phase signal ($\emptyset'(nT)$),

filtering said first phase signal to remove the phase intercept and frequency shift components thereof, thereby providing a second phase signal (output of 36),

passing said second phase signal through a low-pass filter, thereby providing a third phase signal (output of 38), and

passing said third phase signal through a predictive filter to derive therefrom an estimated phase jitter value.

2. The method of claim 1, characterized in that the determination of the phase of the received test signal includes the steps of :

determining the in-phase and quadrature components ($xn$ and $yn$) of the received test signal, and deriving the phase of the received test signal from said components.

3. A device for measuring phase jitter on a transmission channel of the type including means for generating a sinusoidal test signal of a given frequency and for applying said test signal to one end of the transmission channel, and means for measuring the phase jitter affecting the phase of the test signal received at the other end thereof, characterized in that it includes :

means (20, 22, 24, 26) for determining the phase of said test signal received at the other end of the transmission channel,

means (30, 32, 34) for generating the phase of the transmitted test signal,

means (28) for subtracting the test signal phase thus generated from that of the received test signal and for providing a first phase signal,

a second-order recursive filter (36) for removing from said first phase signal the phase intercept and frequency shift components thereof, and for providing a second phase signal,

a low-pass filter (38) for filtering said second phase signal and for providing a third phase signal, and

a predictive and adaptive filter (40) for deriving an estimated phase jitter value from said third phase signal.

4. The device of claim 3, characterized in that said means for determining the phase of the received test signal includes :

a Hilbert transformer (20) for determining the in-phase and quadrature components of the received test signal, and

computing means (26) for deriving the phase of the received test signal from said components.

5. The device of claim 4, characterized in that the received signal is sampled (16) at a first sampling rate before it is applied to said Hilbert transformer (20) ; in that the in-phase and quadrature components of the received test signal are sampled (22, 24) at a second sampling rate which is a sub-multiple of said first sampling rate ; and in that the third phase signal is sampled (70) at a third sampling rate which is a sub-multiple of said second sampling rate.

**Patentansprüche**

1. Verfahren zur Messung des Phasenjitters eines Übertragungskanals, bei dem ein sinusförmiges Testsignal mit einer gegebenen Frequenz ($f_0$) an einem Ende des Übertragungskanals angelegt wird und der Phasenjitter, mit dem das am anderen Ende des Übertragungskanals empfangene Testsignal behaftet ist, gemessen wird, dadurch gekennzeichnet, dass es folgende Stufen umfasst :

Bestimmung der Phase (Ø(nT) des am anderen Ende des Übertragungskanals empfangenen Testsignals (r(t)),

Erzeugung der Phase ($2\pi f_0$nT) des übertragenen Testsignals,

Subtraktion der Phase des erzeugten Testsignals von der des empfangenen Testsignals, wodurch ein erstes Phasensignal (Ø'(nT)) erhalten wird,

Filtern dieses ersten Phasensignals, um die Komponenten des Phasenhubs und der Frequenzablage daraus zu entfernen, wonach dieser Vorgang ein zweites Phasensignal liefert (Ausgang von 36),

Tiefpassfiltern dieses zweiten Phasensignals, wodurch ein drittes Phasensignal erhalten wird (Ausgang von 38), und

Prädiktions-Filtern dieses dritten Phasensignals, um einen geschätzten Wert für den Phasenjitter zu definieren.

2. Verfahren nach Anspruch 1, dadurch gekennzeichnet, dass die Bestimmung der Phase des erhaltenen Testsignals folgende Schritte aufweist :

Bestimmung der Phasenkomponenten und der Komponenten der 90°-Phasenverschiebung (xn und yn) von diesem empfangenen Testsignal, und

auf der Grundlage dieser Komponenten, Bestimmung der Phase des empfangenen Testsignals.

3. Verfahren zur Messung des Phasenjitters eines Übertragungskanals der Art, die Mittel aufweist zum Erzeugen eines sinusförmigen Testsignals gegebener Frequenz und zum Anlegen dieses Signals an einem Ende des Übertragungskanals sowie Mittel, um den Phasenjitter, mit dem das am anderen Ende des Übertragungskanals empfangene Testsignal behaftet ist, zu messen, dadurch gekennzeichnet, dass es aufweist :

Mittel (20, 22, 24, 26), um die Phase des am anderen Ende des Übertragungskanals empfangenen Testsignals zu bestimmen,

Mittel (30, 32, 34), um die Phase des übertragenen Testsignals zu erzeugen,

Mittel (28), um die Phase des erzeugten Testsignals von der des empfangenen Testsignals abzuziehen und ein erstes Phasensignal zu erstellen,

einen rekursiven Filter zweiter Ordnung (36), um die Komponenten des Phasenhubs und der Frequenzablage aus diesem ersten Phasensignal auszuscheiden und so ein zweites Phasensignal zu erstellen,

einen Tiefpassfilter (38), um dieses zweite Phasensignal zu filtern und ein drittes Phasensignal zu erstellen, und

einen prädikativen und adaptativen Filter (40), um vom genannten dritten Phasensignal ausgehend einen geschätzten Wert für den den Phasenjitter zu definieren.

4. Vorrichtung nach Anspruch 3, dadurch gekennzeichnet, dass die Mittel zur Bestimmung der Phase des empfangenen Testsignals umfassen :

einen Hilbert-Transformator (20), um die Komponenten der Phase und der 90°-Phasenverschiebung des empfangenen Testsignals zu bestimmen, und

eine Rechenvorrichtung (26), um die Phase des empfangenen Testsignals auf der Grundlage dieser Komponenten zu berechnen.

5. Vorrichtung nach Anspruch 4, dadurch gekennzeichnet, dass das empfangene Signal mit einem ersten Takt in Abschnitte zerlegt wird (16) bevor es an den Hilbert-Transformator (20) gelegt wird, dass Komponenten des empfangenen Testsignals in Phase und mit 90°-Phasenverschiebung mit einem zweiten Takt in Abschnitte zerlegt werden (22, 24), wobei der genannte erste Takt ein vielfaches dieses zweiten Taktes ist, und dass das dritte Phasensignal mit einem dritten Takt in Abschnitte zerlegt wird (70), wobei der genannte zweite Takt ein Vielfaches dieses dritten Taktes ist.

FIG.1

FIG. 2

FIG.3

FIG.4